# EUROPEAN PATENT APPLICATION

(11) **EP 1 548 746 A2**
(43) Date of publication of application: **29.06.2005**
(21) Application number: 04026058.0
(22) Date of filing: 03.11.2004
(51) Int. Cl.: G11C 13/02

(54) **High-density recording media**

(30) Priority: 07.11.2003 JP 2003379054
(71) Applicant: TOYOTA JIDOSHA KABUSHIKI KAISHA, Toyota-shi, Aichi 471-8571 (JP)
(72) Inventor: Kishita, Keisuke, Toyota-shi Aichi 471-8571 (JP)
(74) Representative: Leson, Thomas Johannes Alois, Dipl.-Ing.

(57) **Abstract**

A high-density recording medium comprising a fullerene/carbon nanotube complex (peapod) comprising a single-wall carbon tube in which fullerenes are inserted in series. A structural difference between a locally bound portion and a non-bound portion of the series of fullerenes is recorded as binary information. The limit of storage capacity in conventional recording media based on micrometer-level binarization information recording techniques can be overcome, and a nanoscale binarization information recording technique is provided.

## Description

### BACKGROUND OF THE INVENTION

### Field of the Invention

The present invention relates to high-density recording media in which a nanoscale structural change in fullerenes contained in carbon nanotubes is utilized.

### Background Art

Recent advances in information recording technologies have resulted in a dramatic increase in the recording density of magnetic recording media, magneto-optical recording media, and thermal phase-change media. For example, optical disc storage media, such as CD-ROMs, CD-Rs, CD-RWs, and DVDs, and magneto-optical storage media, such as MOs and MDs, have been put to practical use.

In these media, digital information is stored as binary information of "0s" and "1s," taking advantage of the property of material. Specifically, in CD-ROMs and DVD-ROMs, pits are formed (the difference between a pit portion and a flat portion in laser light reflection is binarized). In CD-Rs and DVD-Rs, thermal deformation of organic pigments is utilized (the difference between a deformed portion and a non-deformed portion in laser light reflection is binarized). CD-RWs and DVD-RWs utilize a phase change (the difference between a crystalline portion and an amorphous portion in laser light reflection is binarized), and MOs and MDs utilize a change in magnetic domain (the difference in magnetic domain is binarized).

However, there is a limit to storage capacity in the aforementioned recording media that are based on binarization. Specifically, the binary information in accordance with the current binarization information recording methods is of a micrometer level. For example, in CD-ROMs, a pit measures 0.83 µm and a pitch 1.6 µm, and in DVD-ROMs, a pit measures 0.64 µm and a pitch 0.74 µm.

Meanwhile, carbon nanotubes (CNTs) are expected to be useful for a variety of fields. JP Patent Publication (Kokai) No. 2002-97009 A and No. 2002-97010 A disclose the inclusion of a variety of substances inside carbon nanotubes (CNTs). Specifically, they describe a hybrid monolayer carbon nanotube that includes a foreign substance, such as endohederal metallofullerene, within the space of the monolayer carbon nanotube cylinder.

Attempts have also been made to use the carbon nanotube as a recording medium. WO00/48195 A1 describes the recording of binary information based on charged transportation of fullerene in a carbon nanotube.

### SUMMARY OF THE INVENTION

It is an object of the invention to provide a nanoscale binarization information recording technique capable of overcoming the limitation of storage capacity of recording media based on conventional, micrometer-level binarization information recording techniques.

The aforementioned object of the invention is achieved by a nanoscale binarization information recording technique whereby the sequence of individual fullerenes in a fullerene/carbon nanotube complex (peapod) consisting of a single-wall carbon nanotube in which fullerenes are inserted in sequence is structurally changed.

In one aspect, the invention provides a high-density recording medium comprising a fullerene/carbon nanotube complex (peapod) comprising a single-wall carbon nanotube in which fullerenes are inserted in series. The structural difference between a locally bound portion and a non-bound portion of the series of fullerenes is recorded as binary information.

In another aspect, the invention provides a method of recording binary information. The method comprises irradiating a fullerene/carbon nanotube complex (peapod) comprising a single-wall carbon nanotube (SWCNT) in which fullerenes are inserted in series with an energy beam while heating the complex, so that only fullerenes at specific sites can bind to each other. The structural difference between a locally bound portion and a non-bound portion of the series of fullerenes is recorded as binary information.

In a third aspect, the invention provides a method of reading binary information in a high-density recording medium comprising a fullerene/carbon nanotube complex (peapod) comprising a single-wall carbon nanotube in which fullerenes are inserted in series, wherein the structural difference between a locally bound portion and a non-bound portion of the series of fullerenes is recorded as binary information. The method comprises reading the structural difference between the locally bound portion and the non-bound portion on the basis of the reflectivity of an energy beam used for irradiation.

By recording and reading the nanoscale structural difference between a locally bound portion and a non-bound portion of the series of fullerenes in the single-wall carbon nanotube as binary information, the present invention enables the storage capacity to be increased by a factor of approximately 1000 or more in terms of pit width and approximately 100 or more in terms of pitch width, for a total factor of approximately 100,000 or more, as compared with conventional, micrometer-level binarization information recording techniques.

### BRIEF DESCRIPTION OF THE DRAWINGS

Fig. 1 schematically illustrates the operation and principle of the invention.
Fig. 2A shows a TEM photograph showing a monolayer CNT filled internally with fullerene C₆₀. Fig. 2B shows a TEM photograph of the monolayer CNT after heating and electron beam irradiation.

### PREFERRED EMBODIMENS OF THE INVENTION

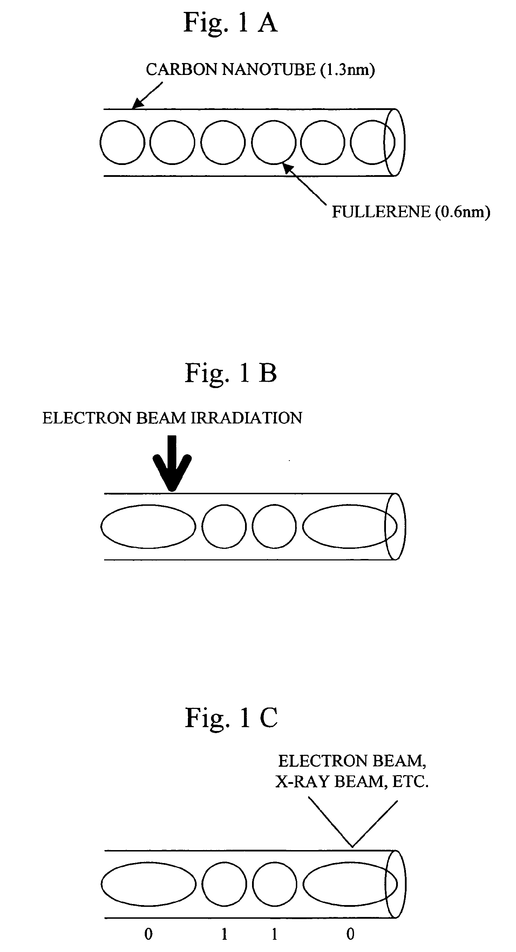

The operation and principle of the present invention are described with reference to the drawings. Fig. 1 schematically illustrates the concept of the invention.

A fullerene/carbon nanotube complex (peapod) consisting of a single-wall carbon nanotube (SWCNT) in which fullerenes are inserted in series is prepared (preparation of a peapod: Fig. 1A).

The complex is heated and then locally irradiated with an energy beam, such as an electron beam, so that two adjacent fullerenes bind to each other, forming a local double-wall carbon nanotube (DWCNT) (binding of fullerenes only at a specific site by localized irradiation: Fig. 1B). The localized irradiation must take place on the order of 1 nm, such as via an electron beam or an X-ray beam. When performed at a certain temperature, the irradiation process can be expected to produce a more stable structure and lead to an improvement of storage accuracy.

The thus formed bound portion is defined as a digital "0" and the non-bound portion that has not been irradiated with the energy beam is defined as a digital "1," or vice versa, such that the structural difference between the locally bound portion and non-bound portion of the fullerene sequence is recorded as binary information. When reading, an energy beam with a lower energy level than that of the previous energy beam is used so as to prevent the inducement of a further binding, and the structural difference between the locally bound portion and non-bound portion, namely the binary information, is read on the basis of reflectance (reading of the binding and non-bound portions in terms of binary information (0 or 1): Fig. 1 C). The reading may be carried out in any way as long as the difference in the state of binding of the fullerenes can be clearly ascertained with an accuracy on the order of 1 nm.

Preferably, the fullerene/carbon nanotube complex (peapod; CNT complex) used in the invention comprises a CNT tube in which a fullerene aggregate consisting mainly of C₆₀ is provided. Such a CNT complex can be readily manufactured or obtained. Since the fullerenes forming the fullerene aggregate are highly symmetrical in shape, a bound portion with a high uniformity of shape (such as in diameter) can be readily formed from such a fullerene aggregate.

The CNT complex used in the invention is made up of a CNT and a plurality of fullerenes contained in or filling the CNT tube. These multiple fullerenes are disposed in series like a chain in the CNT tube, forming a fullerene aggregate. The phrase "disposed in series" herein refers to the condition in which the multiple fullerenes are arranged adjacent to each other, where the fullerenes may not necessarily be in contact with one another physically.

A typical example of the fullerene complex forming the peapod structure is one substantially formed of C₆₀. In the present invention, a CNT complex having a fullerene aggregate substantially formed of C₆₀ is preferably used. In the invention, however, a CNT complex having a fullerene aggregate formed of fullerenes other than C₆₀, such as C₇₀ or C₈₂, may be used. Examples of such fullerene complexes include a fullerene aggregate formed of fullerenes including C₆₀ and C₇₀, and a fullerene aggregate consisting mainly of fullerenes other than C₆₀, such as C₇₀. Part or all of the fullerenes forming such a fullerene complex may be fullerenes containing a substance other than carbon (such as a metal atom, for example).

Although a CNT with both terminals thereof closed could be considered a kind of fullerene, the term "fullerene" herein refers to a spherical or nearly spherical fullerene. The fullerene should preferably be of C₁₀₀ or less.

A CNT complex of the aforementioned structure can be prepared as follows, for example. First, a monolayer CNT with an empty tube interior is provided. The monolayer CNT may be one obtained by the conventional arc discharge method, pulse laser deposition method, or thermal decomposition method, for example, without any particular limitations.

A terminal (tip) of the monolayer CNT is then opened. The terminal of the monolayer CNT can be selectively opened by heating in an oxidizing atmosphere (combustion treatment), or by subjecting it to an acid having an oxidizing property, such as nitric acid (acid treatment), or to another form of oxidizing treatment.

The monolayer CNT with the open terminal and fullerenes are caused to coexist under predetermined conditions so that the fullerenes can be inserted in (fill) the tube of the monolayer CNT. For example, the monolayer CNT with the open terminal and the fullerenes may be caused to coexist at temperature of 350 to 600°C (preferably from 400 to 500°C) for an hour or longer, and typically for 1 to 48 hours. The fullerenes contained in the tube are normally disposed in series to form a fullerene aggregate. A CNT complex is formed in this manner. Alternatively, a CNT complex may be obtained by causing a monolayer CNT whose terminal and/or wall surfaces have been damaged by irradiation with an electron beam, for example, to coexist with fullerenes.

The monolayer CNT (outer tube) forming the CNT complex should preferably have a diameter in the range of approximately 0.8 to 2 nm. A monolayer CNT of such a size can be readily manufactured or obtained. A monolayer CNT with a diameter in the range of approximately 1 to 1.8 nm is particularly preferable. In this case, the fullerene (particularly C₆₀) can be easily made to fill the monolayer CNT, so that a CNT complex can be readily prepared. Further, this allows a fullerene bound portion with little defect to be produced in an electron beam irradiating step, which will be described later. The term "diameter" of the CNT herein refers to the value obtained with respect to the center of the thickness of the wall surface of the CNT. Such a diameter can be measured using a transmission electron microscope (TEM), for example.

In accordance with the invention, irradiation via an energy beam such as an electron beam takes place while the CNT complex is heated. By such irradiation via the electron beam while the CNT complex is heated, recovery from damage (defect) caused by the electron beam can be accelerated as compared with the case of using an electron beam at room temperature. In this way, the reaction for producing a bound portion from the fullerene aggregate is accelerated, while preventing (repairing) the damage done to the outer tube by electron beam irradiation. As a result, a CNT recording medium with only a few defects can be manufactured in a lower temperature range and within a shorter period of time than in the case of only supplying either thermal energy or electron beam energy.

The temperature during electron beam irradiation may be above room temperature, such as in the range from 60 to 1000°C, for example, preferably from 80 to 700°C, and more preferably from 100 to 500°C. If the temperature during electron beam irradiation is higher than the above ranges (such as, for example, in a high temperature range exceeding 1000°C), the high temperature might produce a stronger effect of causing dispersion of carbon than the effect of facilitating recovery from the damage caused by electron beam irradiation. If that happens, manufacturing efficiency of the fullerene bound portion tends to decrease as compared with the case of electron beam irradiation within the above-mentioned temperature ranges. Excessive temperatures during electron beam irradiation are also not preferable from the viewpoint of energy efficiency. On the other hand, if the temperature during electron beam irradiation is lower than the above ranges, the rate of production of the fullerene bound portion might drop, or the effect of facilitating recovery from damage (defect) due to electron beam irradiation might decrease.

The acceleration voltage of the electron beam with which the CNT complex is irradiated may be 80 kV or higher, for example, or typically from 80 to 250 kV. Preferably, the acceleration voltage is 100 kV or higher, or typically from 100 to 225 kV. Particularly preferably, the acceleration voltage is in the range from 100 to 200 kV. If the acceleration voltage is too low, the effect of producing the fullerene bound portion from the fullerene aggregate decreases. If the acceleration voltage is too high, the damage done by electron beam irradiation could possibly exceed the damage-recovery facilitating effect provided by the heating during irradiation.

The amount of electron beam irradiation onto the CNT complex may be in the range from 10 to 2000 C/cm²/min, for example, preferably from 50 to 1000 C/cm²/min, and more preferably from 100 to 500 C/cm²/min. Electron beam irradiation should be carried out with the aforementioned level of irradiation for a period of approximately 5 seconds to 2 hours. The irradiation time is preferably in the range from 15 seconds to 1 hour, and more preferably in the range from 30 seconds to 30 minutes.

An example of the apparatus used in irradiating the CNT complex with an electron beam is JEM-2010 manufactured by JEOL Ltd.

In accordance with the invention, the production efficiency of the fullerene bound portion and its quality (few defects and uniformity of shape, for example) can be significantly improved by adjusting the balance between thermal energy and electron beam energy that are supplied such that the individual energies combine to provide a synergistic effect. An example of such a preferable combination of the energy supply conditions involves a temperature in the range of approximately from 80 to 700°C, and preferably from 200 to 500°C, during electron beam irradiation, and an acceleration voltage of the electron beam used for irradiation in the range from approximately 80 to 250 kV, and preferably from 100 to 200 kV.

The CNT with a form such that the fullerene bound portion and the non-bound portion are contained in a serial manner can be preferably produced by using an electron beam for irradiation with an acceleration voltage in the range from 80 to 150 kV, or more preferably from 100 to 130 kV, while heating the CNT complex to approximately 70 to 250°C, or more preferably 100 to 200°C. The electron beam density should preferably be in the range from 0.5 to 5 × 10⁻¹¹A/cm², and more preferably from 1 to 3 × 10⁻¹¹A/cm².

### Example

### (Example of manufacture of a CNT complex)

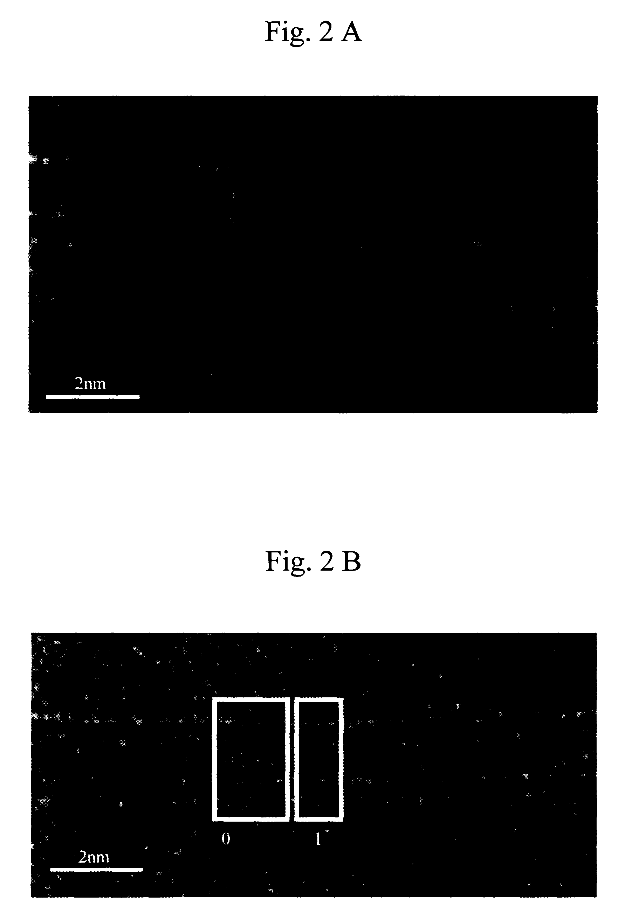

A monolayer CNT complex with an average diameter of 1.5 nm was subjected to an acid treatment so as to open its tip. The monolayer CNT with the thus opened tip and C₆₀ were mixed and retained in vacuum (evacuation level: 1.0 × 10⁻³ Pa) at 450°C for 24 hours. When the resultant product was observed using a transmission electron microscope (TEM) at a magnification of X 500,000, a TEM photograph was obtained as shown in Fig. 2A revealing fullerenes C₆₀ filling the inside of the monolayer CNT. The fullerenes C₆₀ were disposed in series to form a fullerene aggregate. In this way, a CNT complex containing a fullerene aggregate consisting mainly of C₆₀ was prepared.

### (Binding of fullerenes)

The CNT complex thus prepared was then retained (pre-heated) in vacuum with an evacuation level of 1.0 × 10⁻³ Pa at 400°C for an hour. The CNT complex was then irradiated with an electron beam with an acceleration voltage of approximately 120 kV, under the same conditions (temperature and evacuation level), for approximately 5 minutes (the amount of electron beam irradiated: approximately 200 to 250 C/cm²/min). The electron beam density was approximately 3 to 5 × 10⁻¹¹ A/cm². The thus heated and electron-beam-irradiated product was then observed with the TEM under the aforementioned conditions. As a result, a TEM photograph was obtained, as shown in Fig. 2B, revealing a site where two fullerene molecules were bound and another site where a single fullerene molecule existed independently.

In accordance with the invention, a nanoscale high-density recording medium with a peapod structure in which fullerenes are inserted in a carbon nanotube is provided. The high-density recording medium of the invention has a far larger capacity than conventional recording media, and it can therefore be applied in a variety of fields.
A high-density recording medium comprising a fullerene/carbon nanotube complex (peapod) comprising a single-wall carbon tube in which fullerenes are inserted in series. A structural difference between a locally bound portion and a non-bound portion of the series of fullerenes is recorded as binary information. The limit of storage capacity in conventional recording media based on micrometer-level binarization information recording techniques can be overcome, and a nanoscale binarization information recording technique is provided.

## Claims

1. A high-density recording medium comprising a fullerene/carbon nanotube complex (peapod) comprising a single-wall carbon nanotube in which fullerenes are inserted in series, wherein the structural difference between a locally bound portion and a non-bound portion of the series of fullerenes is recorded as binary information.

2. A method of recording a structural difference between a bound portion and a non-bound portion as binary information in a fullerene/carbon nanotube complex (peapod) comprising a single-wall carbon nanotube in which fullerenes are inserted in series, said method comprising irradiating said complex with an energy beam when said complex is heated so as to cause only fullerenes at specific sites to bind to each other.

3. A method of reading a high-density recording medium comprising a fullerene/carbon nanotube complex (peapod) comprising a single-wall carbon nanotube in which fullerenes are inserted in series, wherein the structural difference between a locally bound portion and a non-bound portion of said series of fullerenes is recorded as binary information, said method comprising irradiating said medium with an energy beam and reading said structural difference between said locally bound portion and said non-bound portion on the basis of the reflectivity of said energy beam.
